# EUROPEAN PATENT APPLICATION

(11) **EP 4 715 867 A1**
(43) Date of publication of application: **25.03.2026**
(21) Application number: 24807079.9
(22) Date of filing: 07.05.2024
(51) Int. Cl.: H01L 21/02, B23K 26/57, H01L 21/268

(54) **METHOD FOR REPAIRING JUNCTION**

(30) Priority: 15.05.2023 JP 2023079786
(71) Applicant: Tazmo Co., Ltd., Okayama-shi, Okayama 701-1221 (JP)
(72) Inventor: IKAGAWA Yoshinori, Okayama-shi, Okayama 701-1221 (JP)
(74) Representative: Knöner, Gregor
(86) International application number: PCT/JP2024/016927
(87) International publication number: WO 2024/237126

(57) **Abstract**

A joining correction method corrects a joined state at an unjoined part by applying laser light to the unjoined part if the unjoined part occurs in at least a part of a joining intended site in a joining process of joining two joining targets to each other at the joining intended site set in facing surfaces of the joining targets.

## Description

### Technical Field

The present invention relates to a joining technique using laser light.

### Background Art

One of existing techniques of manufacturing semiconductor devices is a technique including a process of joining two semiconductor wafers to each other (hereinafter called a "joining process"). For example, Patent Literature 1 describes a technique by which, with two semiconductor wafers laid on each other, a pressure is applied using gas or liquid from the side of a back surface of one of the semiconductor wafers and the pressure is received on the side of a back surface of the other, thereby interposing the two semiconductor wafers under pressure, and in this state, laser light is applied to facing surfaces of the semiconductor wafers to join their wafers to each other.

According to the technique of manufacturing semiconductor devices, such a joining process has recently been used in the case of sealing a sensor (such as an acceleration sensor or a gyroscopic sensor) or a micromachine (such as an actuator) in a device, or in the case of manufacturing a semiconductor device having a three-dimensional structure including stacked chips.

### Citation List

### Patent Literature

Patent literature 1: Japanese patent application No. 2022-92779

### Summary of Invention

### Technical Problem

As described in Patent Literature 1, in the above joining process, a holding part for holding the semiconductor wafers may be required in interposing the semiconductor wafers under pressure with the semiconductor wafers laid on each other. In this case, it is impossible to apply laser light to parts of the semiconductor wafers held by the holding part even if joining is required at these parts, so that these parts become unjoined parts. The occurrence of such unjoined parts might cause a problem that these parts become useless or a problem that machining or an apparatus will be subjected to adverse influence (such as adverse influence due to unstable behaviors or peeling of the semiconductor wafers) in a subsequent step (cutting process, for example).

Even if laser light can be applied by some method to the parts held by the holding part, a problem might still occur that a suitable pressure cannot be applied to the parts held by the holding part in a previous step (a step of interposing the semiconductor wafers under pressure) to eventually cause joining failure at these parts, so that these parts become unjoined parts. This problem might occur similarly if the semiconductor wafers are to be joined to each other by being heated entirely while being interposed under pressure. More specifically, if a holding part such as the one described above is required, a pressure necessary for the interposition under pressure becomes insufficient at the parts held by the holding part even if joining is required at these parts, thereby causing the similar problem.

The present invention is intended to provide a technique by which, even if an unjoined part might occur in a joining process of providing joining between joining targets such as semiconductor wafers, it still becomes possible to form a favorable joined state between the joining targets.

### Solution to Problem

A joining correction method according to the present invention corrects a joined state at an unjoined part by applying laser light to the unjoined part if the unjoined part occurs in at least a part of a joining intended site in a joining process of joining two joining targets to each other at the joining intended site set in facing surfaces of the joining targets.

According to the above joining correction method, using laser light makes it possible to limit a place to be heated to the unjoined part. As a result, while the joined state at the unjoined part is corrected, it is possible to prevent a part other than the unjoined part from being influenced adversely by heat or light.

### Advantageous Effects of Invention

According to the present invention, even if an unjoined part might occur in the joining process, it still becomes possible to form a favorable joined state between the joining targets.

### Brief Description of Drawings

FIG. 1A is a sectional view conceptually showing examples of two joining targets to be joined to each other by a joining process, and FIG. 1B is a plan view showing these examples while one joining target of the two joining targets is omitted.
FIGS. 2A and 2B are conceptual views each showing an example of a joining apparatus used in the joining process. FIG. 2A shows a state with a second stage in a moved-up position. FIG. 2B shows a state with the second stage in a moved-down position.
FIG. 3 is a conceptual view showing a state where an unjoined part occurs in a joining intended site.
FIG. 4A is a conceptual view showing an example of a joining correction apparatus used in a joining correction method according to an embodiment, and FIG. 4B is a plan view showing an example of a first support unit used in the embodiment.
FIG. 5A is a plan view conceptually showing arrangement of a joining target with respect to a support mechanism of the joining correction apparatus, and FIG. 5B is a plan view conceptually showing arrangement of the joining target after rotating the joining target in a peripheral direction.
FIGS. 6A and 6B are conceptual views showing a bypass site and a linear site respectively set again as the joining intended site for avoiding an intervening object.

### Description of Embodiments

### [1] Joining Process

### [1-1] Joining Target

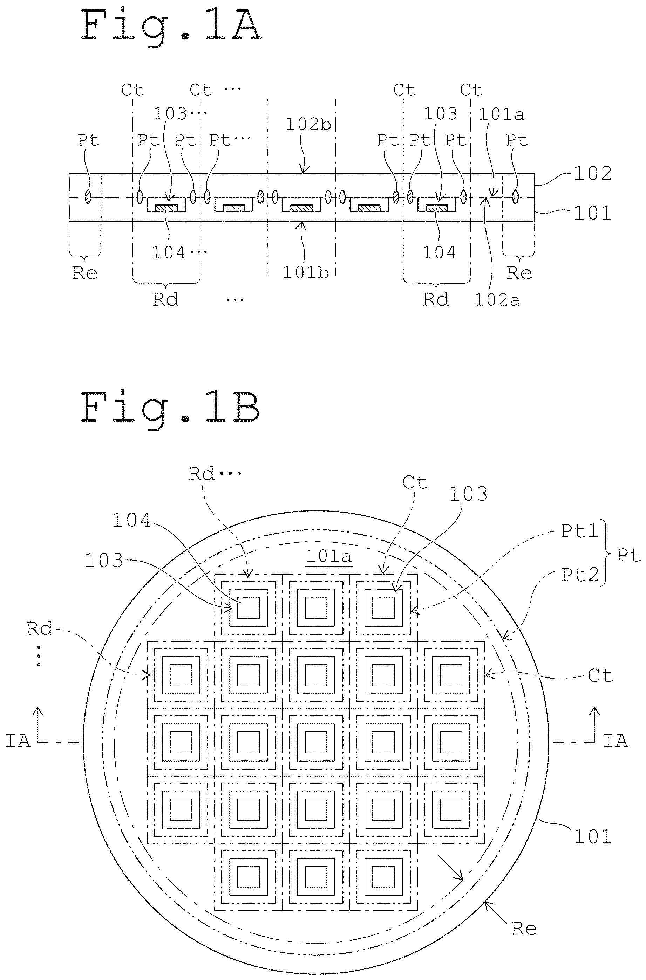

FIGS. 1A and 1B are a sectional view and a plan view respectively each conceptually showing an example of two joining targets 101 and 102 to be joined to each other by a joining process. The joining targets 101 and 102 are base materials composed of substrates such as semiconductor wafers. FIG. 1A is a sectional view taken along a line IA-IA shown in FIG. 1B. FIG. 1B is a plane showing these examples while one joining target 102 is omitted from the two joining targets 101 and 102.

In the example in FIGS. 1A and 1B, the joining target 101 includes a plurality of device regions Rd to be singulated individually by cutting along cutting lines Ct. Each device region Rd becomes a base part of a device by being singulated individually. Each device region Rd is provided with a recess 103 for forming a cavity in the device. The cavity mentioned herein is an enclosed space for sealing therein an element 104 which fulfills a function of the device. The element 104 is a sensor (such as an acceleration sensor or a gyroscopic sensor), a micromachine (such as an actuator), or an electronic circuit, for example.

After the element 104 is placed in the recess 103 in each device region Rd of the joining target 101, the joining target 102 is joined to the joining target 101 while closing each recess 103. By doing so, the cavity is formed in each device region Rd and the element 104 is sealed in the cavity. The joining target 102 is divided into individual pieces together with the joining target 101 by the cutting of the joining target 101 along the cutting lines Ct, thereby functioning as a lid of each device.

As shown in FIG. 1A, this joining between the joining targets 101 and 102 is realized at a joining intended site Pt set in facing surfaces 101a and 102a of the joining targets 101 and 102. In the example in FIG. 1B, in order to achieve joining around the recess 103 over the entire perimeter in each device region Rd, a quadrangular linear site Pt1 is set as the joining intended site Pt for the joining around the recess 103 along the cutting lines Ct. Here, the joining at the linear site Pt1 is joining that is required, even after singulation by the cutting along the cutting lines Ct, to maintain the cavity as the enclosed space in each device resulting from the singulation.

In the example in FIG. 1B, as the joining intended site Pt, an annular linear site Pt2 is further set in peripheral portions Re of the joining targets 101 and 102 for joining the joining targets 101 and 102 to each other over the entire perimeter. The joining at the linear site Pt2 is required to prevent unstable behaviors of the joining targets 101 and 102 that might be caused in the peripheral portions Re in a cutting process (cutting along the cutting lines Ct).

In the joining process, in order to join the two joining targets 101 and 102 to each other at the joining intended site Pt having the pattern shapes described above, laser light is applied to the joining intended site Pt. More specifically, the joining process is performed using a joining apparatus having a configuration described below.

The shapes of the joining targets 101 and 102 and the pattern shape of the joining intended site Pt are not limited to those described above but may be changed, as appropriate, in response to the shape or size of a device to be manufacture or in response to a position, a line, or a region for joining, for example. Joining between the joining targets 101 and 102 is not limited to joining realized by applying laser light to the joining intended site Pt but may be changed, as appropriate, to joining realized by setting a region where the joining targets 101 and 102 are to be pressurized as the joining intended site Pt and heating the joining targets 101 and 102 entirely.

### [1-2] Joining Apparatus

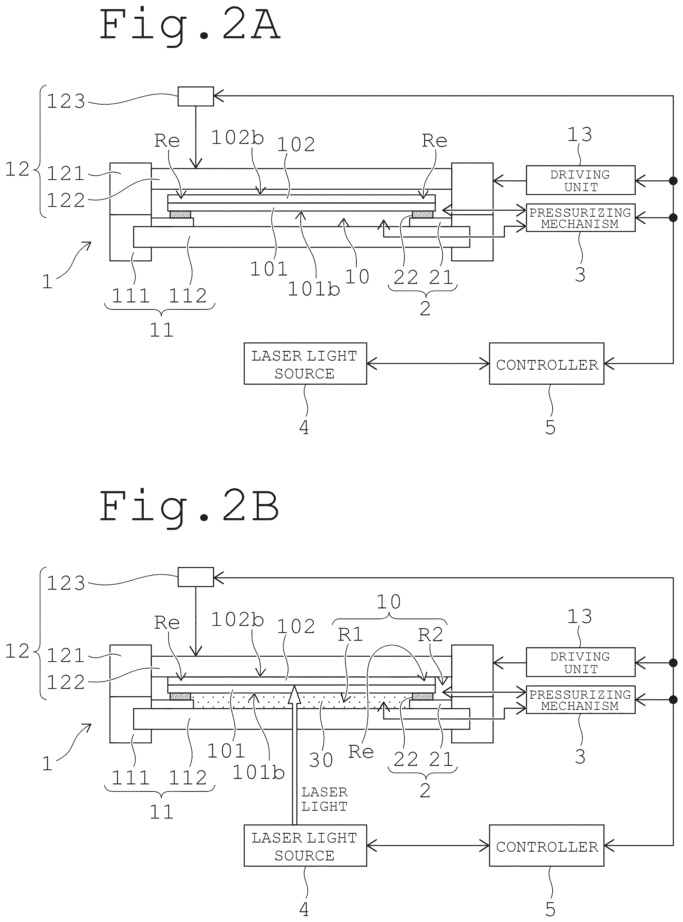

FIG. 2A is a conceptual view showing an example of the joining apparatus used in the joining process. In the example in FIG. 2A, the joining apparatus includes a chamber mechanism 1, a sealing mechanism 2, a pressurizing mechanism 3, a laser light source 4, and a controller 5. The configuration of each unit will be described below in detail.

### <Chamber Mechanism 1>

The chamber mechanism 1 includes a first chamber structure unit 11, a second chamber structure unit 12, and a driving unit 13 that drives at least one of these structure units.

The first chamber structure unit 11 and the second chamber structure unit 12 form an enclosed space (hereinafter called a "chamber 10") for implementation of the joining process. The first chamber structure unit 11 and the second chamber structure unit 12 are configured to realize formation and opening of the chamber 10 selectively by moving closer to and farther from each other in a vertical direction. Particulars thereof will be described below.

The first chamber structure unit 11 is composed of a first circular cylindrical part 111, and a first stage 112 supported inside the first circular cylindrical part 111 with no gap therebetween. The first circular cylindrical part 111 is arranged with a center axis thereof extending in a direction conforming to the vertical direction. The first stage 112 is supported horizontally by the first circular cylindrical part 111. Here, the first stage 112 is transmissive to laser light and is made of quartz, for example.

The second chamber structure unit 12 is composed of a second circular cylindrical part 121 arranged over the first circular cylindrical part 111 and coaxially with the first circular cylindrical part 111, a second stage 122 supported inside the second circular cylindrical part 121 with no gap therebetween in such a manner as to be movable up and down, and a driving unit 123 for moving the second stage 122 up and down. An upper end of the first circular cylindrical part 111 and a lower end of the second circular cylindrical part 121 contact each other with no gap therebetween, thereby forming the chamber 10 between the first stage 112 and the second stage 122 as shown in FIGS. 2A and 2B. FIG. 2A shows a state with the second stage 122 in a moved-up position. FIG. 2B shows a state with the second stage 122 in a moved-down position.

By moving down the second stage 122 to bring the second stage 122 into surface contact with a back surface 102b of the joining target 102 as shown in FIG. 2B, when the pressurizing mechanism 3 described later applies a pressure to a back surface 101b of the joining target 101 from the side of the first stage 112 (in the example in FIG. 2B, from a lower side), the applied pressure can be received on the side of the back surface 102b of the joining target 102 (in the example in FIG. 2B, on an upper side). In this way, in this joining apparatus, the second stage 122 is capable of functioning as a support to receive the pressure on the side of the back surface 102b of the joining target 102.

The driving unit 13 moves at least one of the first chamber structure unit 11 and the second chamber structure unit 12 in the vertical direction, thereby causing these structure units to move closer to and farther from each other relatively.

### <Sealing Mechanism 2>

The sealing mechanism 2 partitions space in the chamber 10 into a plurality of regions (hereinafter called "chamber regions") and provides sealing between the chamber regions next to each other (see FIG. 2B). More specifically, the sealing mechanism 2 partitions the space in the chamber 10 into a first chamber region R1 facing the back surface 101b of the joining target 101 and a second chamber region R2 next to the first chamber region R1, and provides sealing between these chamber regions. Particulars thereof will be described below.

The sealing mechanism 2 is composed of a flange part 21 and a holding part 22. The flange part 21 is an annular part protruding from a position along an inner surface of the first circular cylindrical part 111 and higher than the first stage 112 (namely, a position close to the second circular cylindrical part 121) toward the center axis of the first circular cylindrical part 111. The flange part 21 extends to a position where the flange part 21 can come to face the peripheral portions Re of the joining targets 101 and 102 when the joining targets 101 and 102 are placed in the chamber 10. The holding part 22 is composed of a sealing member (such as an O-ring) having an annular shape, and is provided on an upper surface of a tip of the flange part 21 in order to be capable of supporting the peripheral portions Re of the joining targets 101 and 102 over the entire perimeter when the joining targets 101 and 102 are placed in the chamber 10.

With the above sealing mechanism 2, when the second stage 122 is moved down to come into contact with the back surface 102b of the joining target 102, the peripheral portions Re of the joining targets 101 and 102 are interposed over the entire perimeter between the second stage 122 and the holding part 22. As a result, as shown in FIG. 2B, the space in the chamber 10 is partitioned into the first chamber region R1 and the second chamber region R2 and sealing is provided between these chamber regions.

### <Pressurizing Mechanism 3>

The pressurizing mechanism 3 applies a pressure to the back surface 101b of the joining target 101 by increasing an internal pressure in the first chamber region R1. More specifically, the pressurizing mechanism 3 uses gas or liquid as a pressure transmission medium 30. With the pressure transmission medium 30 in contact with the back surface 101b of the joining target 101, the pressurizing mechanism 3 applies a pressure to the back surface 101b. Particulars thereof will be described below.

The pressurizing mechanism 3 is capable of adjusting internal pressures individually in the chamber regions resulting from the partitioning of the chamber 10 by the sealing mechanism 2. The pressurizing mechanism 3 is capable of reducing a pressure in each chamber region, and further capable of applying a pressure to the first chamber region R1 using the pressure transmission medium 30. The pressure is applied to the first chamber region R1 by supplying the pressure transmission medium 30 (gas or liquid) to the first chamber region R1 using a compression pump, for example. The pressurizing mechanism 3 makes an internal pressure in the first chamber region R1 higher than an internal pressure in the second chamber region R2, thereby applying a pressure to the back surface 101b of the joining target 101 using a difference between the internal pressures.

### <Laser Light Source 4>

The laser light source 4 is to emit laser light, and is arranged below the first stage 112 transmissive to laser light. The laser light source 4 is capable of performing a scan with laser light within a horizontal plane along the pattern shape of the joining intended site Pt while applying the laser light to the joining targets 101 and 102 through the first stage 112. The laser light source 4 is further capable of focusing the laser light on a place of joining between the joining targets 101 and 102 (the position of the joining intended site Pt).

### <Controller 5>

The controller 5 is composed of a processor such as a CPU or a microcomputer, and controls various operation units (including the chamber mechanism 1, the pressurizing mechanism 3, and the laser light source 4) of the joining apparatus. More specifically, the controller 5 exerts control in line with a flow described below to perform the joining process.

First, the controller 5 moves the first chamber structure unit 11 and the second chamber structure unit 12 closer to each other to unite these structure units, thereby forming the chamber 10 (see FIG. 2A). At this time, the joining targets 101 and 102 are placed over the holding part 22 before formation of the chamber 10.

Next, the controller 5 controls the pressurizing mechanism 3 to reduce an internal pressure in the chamber 10 entirely until a vacuum state is formed in the chamber 10. At this time, as the peripheral portions Re of the joining targets 101 and 102 are in a state before being interposed between the second stage 122 and the holding part 22, they are released from sealing. Thus, gas present between the joining targets 101 and 102 is allowed to pass through between the joining targets 101 and 102 to flow out to an external place (inside the chamber 10). This further achieves reduction in an internal pressure between the joining targets 101 and 102.

The controller 5 thereafter moves down the second stage 122 to bring the second stage 122 into contact with the back surface 102b of the joining target 102, thereby interposing the peripheral portions Re of the joining targets 101 and 102 over the entire perimeter between the second stage 122 and the holding part 22 (see FIG. 2B). By doing so, the first chamber region R1 and the second chamber region R2 are formed and sealing is provided therebetween.

In this state, the controller 5 controls the pressurizing mechanism 3 to increase an internal pressure in the first chamber region R1 while maintaining a vacuum state in the second chamber region R2. This makes the internal pressure in the first chamber region R1 higher than an internal pressure in the second chamber region R2 and a pressure responsive to a difference between the internal pressures is applied to the back surface 101b of the joining target 101. As a result, the joining targets 101 and 102 are interposed under pressure between the pressure transmission medium 30 and the second stage 122 (pressurizing step). At this time, by changing the internal pressure in the first chamber region R1, the pressure to be applied to the back surface 101b of the joining target 101 can be changed to an intended value. As long as the internal pressure in the first chamber region R1 has a higher value than the internal pressure in the second chamber region R2, it may be set to a value lower than atmospheric pressure, to a value substantially equal to atmospheric pressure, or to a value higher than atmospheric pressure.

After applying the pressure to the back surface 101b of the joining target 101 with the pressurizing mechanism 3, while the controller 5 maintains a state of applying the pressure to this back surface 101b, the controller 5 controls the laser light source 4 to apply laser light to the joining intended site Pt of the joining targets 101 and 102. At this time, the controller 5 performs a scan with the laser light within a horizontal plane along the pattern shape of the joining intended site Pt. In this way, the joining apparatus performs the joining process of joining the two joining targets 101 and 102 to each other.

The above joining apparatus is not limited to an apparatus that joins the joining targets 101 and 102 to each other by applying laser light to the joining intended site Pt having the pattern shape. As appropriate, the joining apparatus may be changed to an apparatus that joins the joining targets 101 and 102 to each other by setting a region where the joining targets 101 and 102 are to be pressurized as the joining intended site Pt and heating the joining targets 101 and 102 entirely.

### [1-3] Occurrence of Unjoined part

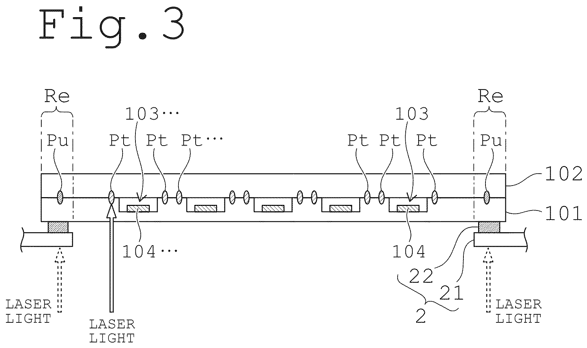

In the above joining apparatus, the peripheral portions Re of the joining targets 101 and 102 are interposed over the entire perimeter between the second stage 122 and the holding part 22 during implementation of the joining process (see FIGS. 1B and 2B). Thus, as shown in FIG. 3, during application of laser light to the joining intended site Pt, the presence of the sealing mechanism 2 including the holding part 22 makes it impossible to apply laser light to a part of the joining intended site Pt (the annular linear site Pt2) set in the peripheral portions Re. As a result, this part becomes an unjoined part Pu. On the occurrence of this unjoined part Pu, it becomes impossible to prevent unstable behaviors of the joining targets 101 and 102 that might be caused at the peripheral portions Re in the cutting process (cutting along the cutting lines Ct).

This occurs not only in the case of performing the joining process using the above joining apparatus. If a holding part for holding the joining targets 101 and 102 is required in interposing the two joining targets 101 and 102 under pressure with the joining targets 101 and 102 laid on each other, a part of the joining intended site Pt may be hidden by the holding part (and by a mechanism including the holding part). In this case, it is impossible to apply laser light to the part of the joining intended site Pt hidden by the holding part, so that this part becomes the unjoined part Pu. In addition to the above problem of unstable behaviors, the occurrence of this unjoined part Pu might cause a problem that an area where the unjoined part Pu occurs becomes useless or a problem that machining or an apparatus will be subjected to adverse influence (such as peeling) in a subsequent step.

Even if it is possible in some way to apply laser light to the part of the joining intended site Pt hidden by the holding part (and by the mechanism including the holding part), a problem might still occur that a suitable pressure cannot be applied to the part held by the holding part in the previous step (the step of interposing the joining targets 101 and 102 under pressure) to eventually cause joining failure at this part, so that this part becomes the unjoined part Pu. This problem might occur similarly if a holding part such as the one described above is required in the case of joining the joining targets 101 and 102 to each other by entirely heating the joining targets 101 and 102 while interposing them under pressure, as a pressure necessary for the interposition under pressure becomes insufficient at a part held by the holding part.

In order to allow formation of a favorable joined state between the joining targets 101 and 102 even if the unjoined part Pu might occur in the joining process as described above, the present inventor suggests a joining correction method of correcting a joined state at the unjoined part Pu by applying laser light to the unjoined part Pu. The joining correction method will be described below in detail.

In addition to the reasons given above, the unjoined part Pu might occur for a reason that a foreign object gets stuck between the two joining targets 101 and 102 to hinder tight contact between the joining targets 101 and 102 due to the foreign object, or a reason that output from the laser light source 4 becomes insufficient temporarily to cause the power of the laser light to become insufficient to joining. A joining correction method of correcting a joined state at the unjoined part Pu resulting from these reasons will be described later in a second modification.

### [2] Joining Correction Method

The joining correction method according to the embodiment can be implemented using a joining correction apparatus described below.

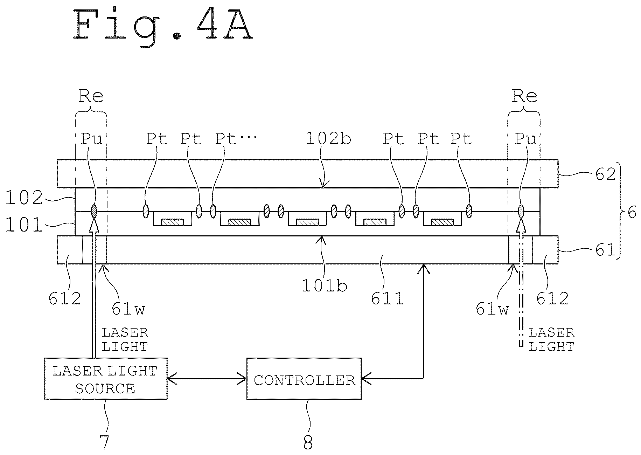

FIG. 4A is a conceptual view showing an example of the joining correction apparatus. The joining correction apparatus includes a support mechanism 6, a laser light source 7, and a controller 8.

The support mechanism 6 includes a first support unit 61 and a second support unit 62. After the joining targets 101 and 102 are subjected to the joining step described above, the support mechanism 6 supports the joining targets 101 and 102 by interposing the joining targets 101 and 102 from the sides of the respective back surfaces 101b and 102b thereof using the first support unit 61 and the second support unit 62. The support mechanism 6 may further have a pressurizing function of interposing the joining targets 101 and 102 under pressure while supporting the joining targets 101 and 102 using the first support unit 61 and the second support unit 62.

In the present embodiment, the first support unit 61 is arranged on the side of incidence of laser light with respect to the joining targets 101 and 102 (in the example in FIG. 4A, on the side of the back surface 101b of the joining target 101). A support unit used as the first support unit 61 is provided with a window 61w for allowing laser light from the laser light source 7 to pass therethrough. More specifically, the window 61w is formed at the first support unit 61 in such a manner as to allow at least a part of the unjoined part Pu to be exposed through the window 61w when the joining targets 101 and 102 are interposed between the first support unit 61 and the second support unit 62.

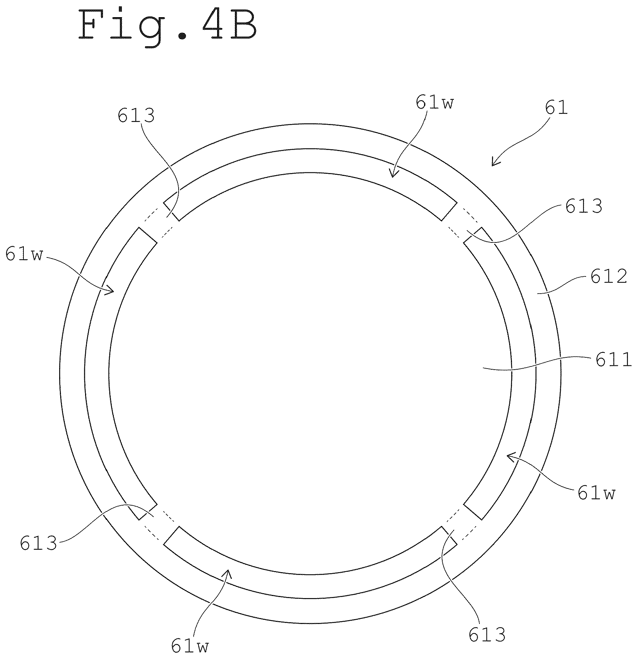

FIG. 4B is a plan view showing an example of the first support unit 61 used in the embodiment. The first support unit 61 shown in FIG. 4B is available for correcting a joined state at the unjoined part Pu in a case where the annular linear site Pt2 of the joining intended site Pt shown in FIG. 1B becomes the unjoined part Pu (in other words, a case where the unjoined part Pu occurs in the peripheral portions Re of the two joining targets 101 and 102).

More specifically, the first support unit 61 is composed of a body part 611, an annular part 612, and a beam part 613. The body part 611 is to come into contact with a central region of the back surface 101b of the joining target 101 internal to the peripheral portion Re (see FIG. 4A). The annular part 612 is to come into contact with an annular region of the back surface 101b of the joining target 101 including an outer periphery thereof, which is an annular region having a smaller width than the peripheral portion Re (see FIG. 4A). The beam part 613 connects the annular part 612 to the body part 611 in at least one place (see FIG. 4B). A region surrounded by the body part 611, the annular part 612, and the beam part 613 functions as the window 61w of the first support unit 61. According to the first support unit 61 shown in the example in FIG. 4B, with the four beam parts 613 arranged at an equal distance around a central point of the first support unit 61, the annular part 612 is connected to the body part 611 in four places, and as a result, the four windows 61w are formed. The configuration of the first support unit 61 (including the shape of the window 61w, the number of the windows 61w, etc.) is not limited to that shown in FIG. 4B but may be changed, as appropriate, to a configuration responsive to the shape of the unjoined part Pu occurring in the joining intended site Pt, for example.

The laser light source 7 is to emit laser light, and is capable of applying laser light through the window 61w of the first support unit 61 toward the joining targets 101 and 102 supported by the support mechanism 6. More specifically, the laser light source 7 is capable of applying laser light through the window 61w of the first support unit 61 to the unjoined part Pu exposed through the window 61w. The laser light source 7 is capable of performing a scan with laser light within a horizontal plane along the pattern shape of the unjoined part Pu (here, the pattern shape of the annular linear site Pt2). The laser light source 4 is further capable of focusing the laser light on a place of joining between the joining targets 101 and 102 (the position of the unjoined part Pu).

The controller 8 is composed of a processor such as a CPU or a microcomputer, and controls various operation units (including the support mechanism 6 and the laser light source 7) of the joining correction apparatus. More specifically, the controller 8 exerts control in line with a flow described below to perform the joining correction method.

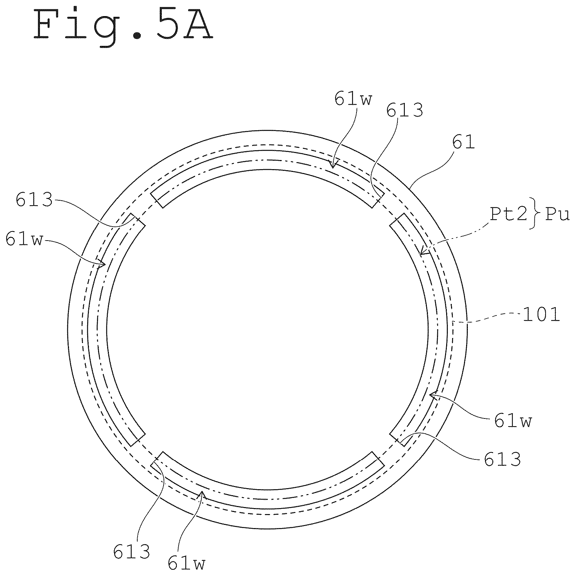

First, the controller 8 supports the joining targets 101 and 102 using the support mechanism 6 (supporting step, see FIG. 4A). At this time, as shown in FIG. 5A, the joining targets 101 and 102 are arranged in such a manner that at least a part of the unjoined part Pu becomes exposed through the window 61w of the first support unit 61. At this time, the controller 8 may interpose the joining targets 101 and 102 under pressure using the first support unit 61 and the second support unit 62 by controlling the support mechanism 6.

The controller 8 thereafter controls the laser light source 7 to apply laser light through the window 61w of the first support unit 61 to the unjoined part Pu exposed through the window 61w (correcting step). At this time, the controller 8 performs a scan with the laser light within a horizontal plane along the pattern shape of the unjoined part Pu (here, the pattern shape of the annular linear site Pt2). By doing so, a joined state is corrected at the part of the unjoined part Pu exposed through the window 61w of the first support unit 61. In this way, the joining correction apparatus performs the joining correction method of correcting the joined state at the unjoined part Pu.

According to the described joining correction method, using laser light makes it possible to limit a place to be heated to the unjoined part Pu. As a result, while a joined state at the unjoined part Pu is corrected, it is possible to prevent a part other than the unjoined part Pu from being influenced adversely by heat or light.

The first support unit 61 allows a surrounding of the unjoined part Pu exposed through the window 61W to be supported at the edge of the window 61w (defined by the body part 611, the annular part 612, and the beam part 613). This allows the two joining targets 101 and 102 to contact each other more tightly at the unjoined part Pu. Thus, by applying laser light to the unjoined part Pu exposed through the window 61w, it becomes possible to correct a joined state at the unjoined part Pu to a favorable state.

### [3] Modifications

### [3-1] First Modification

In the correcting step of the joining correction method described above, while laser light can be applied to a part of the unjoined part Pu exposed through the window 61w of the first support unit 61, laser light cannot be applied to a part of the unjoined part Pu hidden by the beam part 613 to make it impossible to correct a joined state at this part (see FIG. 5A).

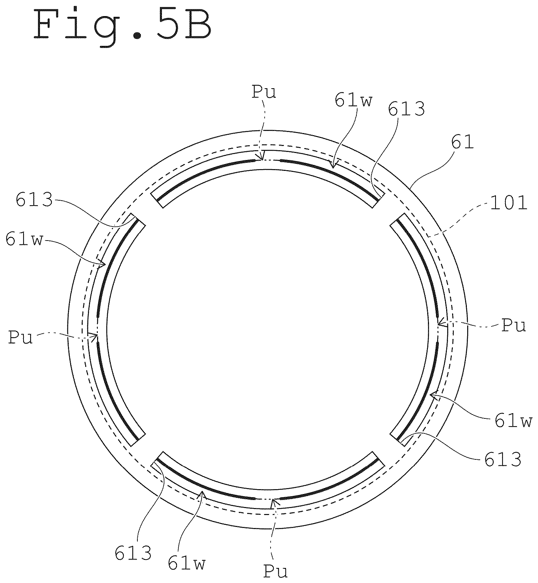

In response to this, as shown in FIG. 5B, the joining targets 101 and 102 may be relocated by being rotated in a peripheral direction after implementation of the correcting step in order to expose the part of the unjoined part Pu hidden by the beam part 613 through the window 61w. In FIG. 5B, a corrected part of the unjoined part Pu is indicated by a thick bold line. The above correcting step may be performed again on the part of the unjoined part Pu that has been hidden by the beam part 613.

According to the described joining correction method, even if it is impossible to correct a joined state at the unjoined part Pu entirely through one correcting step, relocating the joining targets 101 and 102 and performing the correcting step again allows the joined state to be corrected at the unjoined part Pu entirely. Until the time when the joined state is corrected at the unjoined part Pu entirely, such reimplementation of the correcting step can be repeated while the joining targets 101 and 102 are relocated on an as-needed basis.

The joining correction method of the present modification may be changed, as appropriate, to a method that exposes a part of the unjoined part Pu hidden by the beam part 613 through the window 61w by rotating the first support unit 61 of the joining correction apparatus in the peripheral direction (in other words, by rotating the joining targets 101 and 102 in the peripheral direction relative to the first support unit 61) instead of rotating the joining targets 101 and 102 in the peripheral direction to relocate the joining targets 101 and 102.

### [3-2] Second Modification

As described above, the unjoined part Pu might occur for a reason that a foreign object gets stuck between the two joining targets 101 and 102 to hinder tight contact between the joining targets 101 and 102 due to the foreign object, or a reason that output from the laser light source 4 becomes insufficient temporarily to cause the power of laser light to become insufficient to joining. Unlike in the above case of the embodiment (specifically, in a case where it is clear that a part of the joining intended site Pt held by the holding part becomes the unjoined part Pu), in the case of the unjoined part Pu that might occur for these reasons, it is unclear whether the unjoined part Pu actually occurs at the time of completion of the joining process and the position of the occurrence of the unjoined part Pu is also unclear even if the unjoined part Pu occurs.

In order to allow formation of a favorable joined state between the joining targets 101 and 102 even if the unjoined part Pu might occur for the above reasons, the present inventor further suggests a joining correction method described below.

First, a joined state at the joining intended site Pt at a moment after the joining process is inspected to identify the unjoined part Pu occurring in this joining intended site Pt (identifying step). Next, laser light is applied to the unjoined part Pu identified in the identifying step to correct the joined state at this unjoined part Pu (correcting step).

As a specific example, a consideration is given to a case where the unjoined part Pu occurs in a region where a pressure is applicable using the pressure transmission medium 30 (a region where laser light is applicable, in other words, a region other than a part where application of laser light is hindered by the presence of the sealing mechanism 2 including the holding part 22) when the joining process is performed using the joining apparatus shown in FIG. 2A.

A consideration is first given to a case where the unjoined part Pu is caused by insufficiency of the power of laser light. In this case, after the unjoined part Pu is identified in the identifying step, the joining apparatus having been used in the joining process (see FIG. 2A) is used again to interpose the joining targets 101 and 102 under pressure (pressurizing step). Then, in the correcting step, laser light is applied to the unjoined part Pu in a state where the insufficiency of the power of laser light has been resolved, thereby allowing a joined state at the unjoined part Pu to be corrected.

Next, a consideration is given to a case where the unjoined part Pu is caused by a foreign object (intervening object) stuck between the joining targets 101 and 102. In this case, at the joining targets 101 and 102 at a moment after the joining process, a protrusion having an apex at the position of the intervening object occurs at the back surface 102b of the joining target 102. Observing the back surface 102b of the joining target 102 with a camera allows the protrusion to be observed as an interference pattern. Thus, in the identifying step, by observing the back surface 102b of the joining target 102 with the camera, it becomes possible to identify a part of the joining intended site Pt as the unjoined part Pu that overlaps the interference pattern having been observed successfully with the camera. Moreover, a center position of the interference pattern can be identified as the position of the intervening object.

In this case, a joined state at the unjoined part Pu can also be corrected using the joining apparatus again having been used in the joining process (see FIG. 2A). On the other hand, as the unjoined part Pu is caused by the intervening object, the intervening object cannot be removed and thus the protrusion having the apex at the position of the intervening object cannot be extinguished. Moreover, if the intervening object is present on the unjoined part Pu, applying laser light even directly to the unjoined part Pu caused by the intervening object still makes it difficult to improve a joined state at the unjoined part Pu.

This is handled, before implementation of the correcting step, by applying a pressure using the pressure transmission medium 30 (pressurizing step) larger than a pressure having been applied to the back surface 101b of the joining target 101 at the time of interposing the joining targets 101 and 102 under pressure during the joining process. This allows the protrusion to contract as much as possible, making it possible to increase a region of tight contact between the joining targets 101 and 102 around the intervening object.

In the correcting step, while the protrusion is kept in the state of contracting as much as possible by the pressurizing step, laser light is applied while avoiding the position of the intervening object identified in the identifying step, thereby correcting a joined state at the unjoined part Pu.

If the intervening object is at a shifted position from the unjoined part Pu, it is possible to correct a joined state at the unjoined part Pu by minimizing the protrusion to reduce influence by the intervening object in the pressurizing step and then applying laser light directly to the unjoined part Pu.

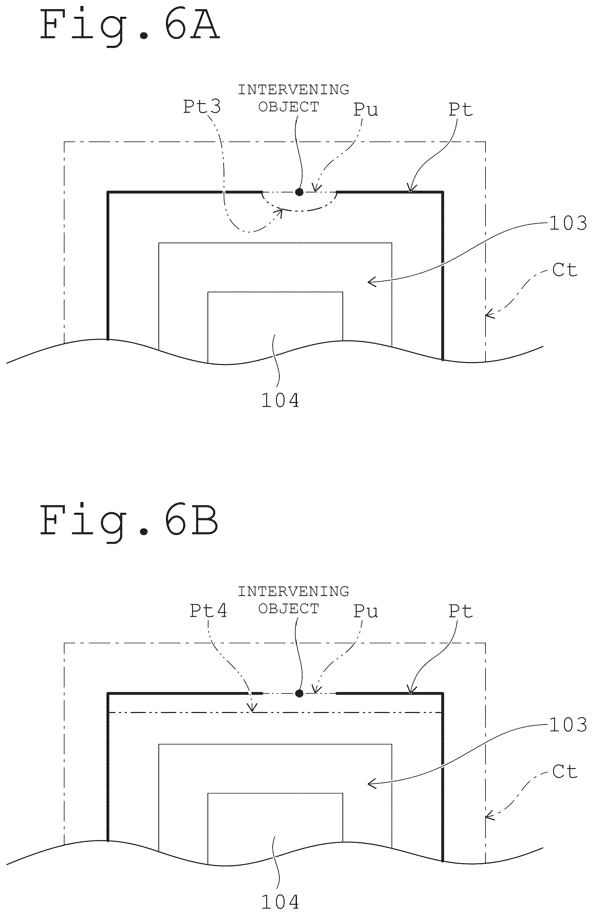

On the other hand, if the intervening object is present on the unjoined part Pu, laser light is applied to a position shifted from the unjoined part Pu while avoiding the position of the intervening object to provide joining at the shifted position, thereby compensating for correction of a joined state at the unjoined part Pu. As an example, as shown in FIG. 6A, a bypass site Pt3 bypassing the position of the intervening object is set again as the joining intended site Pt and laser light is applied to the bypass site Pt3. By doing so, it becomes possible to compensate for correction of a joined state at the unjoined part Pu. In FIG. 6A, a part of the joining intended site Pt where joining has been completed is indicated by a thick bold line (this also applies to FIG. 6B). As another example, as shown in FIG. 6B, it is possible to compensate for correction of a joined state at the unjoined part Pu by setting a different linear site Pt4 again as the joining intended site Pt along a part (including a part where joining has been completed) of the joining intended site Pt including the unjoined part Pu, and applying laser light to the linear site Pt4 (see FIG. 6B).

Application of laser light to the unjoined part Pu in the correcting step is conducted not only in a case where the laser light is applied directly to the unjoined part Pu to correct a joined state at the unjoined part Pu but also in a case where there is a need to avoid the intervening object and correction of a joined state at the unjoined part Pu can be compensated for by applying laser light to a position shifted from the unjoined part Pu while avoiding the intervening object instead of applying laser light directly to the unjoined part Pu.

### [3-3] Third Modification

According to the method of correcting a joined state at the unjoined part Pu employed in the above second modification, if the unjoined part Pu is caused by a foreign object (intervening object) stuck between the joining targets 101 and 102, the pressurizing step is performed before implementation of the correcting step to cause a protrusion resulting from the intervening object to contract as much as possible, thereby increasing a region of tight contact between the joining targets 101 and 102 around the intervening object. Meanwhile, a preparatory processing step described below may be performed instead of the pressurizing step or in parallel with the pressurizing step.

More specifically, before implementation of the correcting step, laser light for a preparatory process is applied to an intervening object present at a position identified in the identifying step, thereby deforming the intervening object by heating or subliming the intervening object through a phenomenon such as ablation (preparatory processing step). By doing so, it becomes possible to reduce the height of the protrusion to eventually allow increase in a region of tight contact between the joining targets 101 and 102 around the intervening object.

If the intervening object is to be deformed by heating with laser light in the preparatory processing step, performing the pressurizing step in parallel presses the heated intervening object with a pressure to allow the intervening object to be deformed efficiently. As a result, it is possible to reduce the height of the protrusion.

If the intervening object is to be sublimed with laser light in the preparatory processing step, performing the pressurizing step in parallel allows gas generated by the sublimation to be pushed out into the cavity with a pressure. As a result, it is possible to extinguish the protrusion. As long as the protrusion can be extinguished, it is possible to apply laser light directly to the unjoined part Pu without avoiding the intervening object in the correcting step.

The above explanations of the embodiments and modifications are nothing more than illustrative in any respect, nor should be thought of as restrictive. The scope of the present invention is indicated by claims rather than the above embodiments or modifications. Furthermore, it is intended that all changes that are equivalent to a claim in the sense and realm of the doctrine of equivalence be included within the scope of the present invention.

As a subject of the invention, each step forming the joining correction method may be extracted individually, or the joining correction apparatus used in the joining correction method or each unit of the joining correction apparatus (such as the first support unit 61) may be extracted individually from the above embodiments or modifications. A part of the joining process or a part of the joining apparatus may be combined with these subjects to be extracted, and resultant subjects may be extracted as subjects of the invention.

### Reference Signs List

1 Chamber mechanism
2 Sealing mechanism
3 Pressurizing mechanism
4 Laser light source
5 Controller
6 Support mechanism
7 Laser light source
8 Controller
10 Chamber
11 First chamber structure unit
12 Second chamber structure unit
13 Driving unit
21 Flange part
22 Holding part
30 Pressure transmission medium
61 First support unit
61w Window
62 Second support unit
Ct Cutting line
Pt Joining intended site
Pu Unjoined part
R1 First chamber region
R2 Second chamber region
Rd Device region
Re Peripheral portion
101, 102 Joining target
101a, 102a Facing surface
101b, 102b Back surface
103 Recess
104 Element
111 First circular cylindrical part
112 First stage
121 Second circular cylindrical part
122 Second stage
123 Driving unit
611 Body part
612 Annular part
613 Beam part
Pt1, Pt2, Pt4 Linear site
Pt3 Bypass site

## Claims

1. A joining correction method of correcting a joined state at an unjoined part by applying laser light to the unjoined part if the unjoined part occurs in at least a part of a joining intended site in a joining process of joining two joining targets to each other at the joining intended site set in facing surfaces of the joining targets.

2. The joining correction method according to claim 1, comprising:
a supporting step that supports the two joining targets by interposing the joining targets from sides corresponding to back surfaces thereof using a first support unit and a second support unit, the first support unit being a support unit that allows at least a part of the unjoined part to be exposed through a window for allowing laser light to pass therethrough; and
a correcting step that applies laser light to the unjoined part through the window after the supporting step, thereby correcting the joined state at the unjoined part.

3. The joining correction method according to claim 2, wherein
if the unjoined part occurs in peripheral portions of the two joining targets, the support unit used as the first support unit includes a body part to come into contact with a central region of the back surface internal to the peripheral portion, an annular part to come into contact with an annular region of the back surface along an outer periphery thereof, and a beam part connecting the annular part to the body part, and a region surrounded by the body part, the annular part, and the beam part functions as the window.

4. The joining correction method according to claim 3, wherein
after implementation of the correcting step, the two joining targets are rotated in a peripheral direction relative to the first support unit to expose a part of the unjoined part hidden by the beam part through the window, and then the correcting step is performed again on the part.

5. The joining correction method according to claim 1, comprising:
a pressurizing step that applies a pressure to the back surface of one joining target of the two joining targets with gas or liquid as a pressure transmission medium in direct contact with this back surface and causes a support unit to receive the pressure on the side of the back surface of the other joining target, thereby interposing the two joining targets under pressure; and
a correcting step that applies laser light to the unjoined part from the side of the back surface of the one joining target while the pressurizing step interposes the two joining targets under pressure, thereby correcting the joined state at the unjoined part.

6. The joining correction method according to claim 5, wherein
the pressurizing step is further used in the joining process, and
in the pressurizing step performed during correction at the unjoined part, a pressure larger than the pressure applied in the pressurizing step performed before the correction is applied to the back surface of the one joining target using the gas or the liquid that is the pressure transmission medium.

7. The joining correction method according to any one of claims 1 to 6, comprising:
an identifying step that inspects the joined state at the joining intended site at a moment after the joining process to identify the unjoined part occurring in the joining intended site; and
a correcting step that applies laser light to the unjoined part identified in the identifying step, thereby correcting the joined state at the unjoined part.

8. The joining correction method according to claim 7, wherein
in the identifying step, the unjoined part is identified, and if the identified unjoined part is caused by an intervening object, the position of the intervening object is identified, and
in the correcting step, laser light is applied while avoiding the position of the intervening object identified in the identifying step, thereby correcting the joined state at the unjoined part.

9. The joining correction method according to any one of claims 1 to 6, comprising:
an identifying step that inspects the joined state at the joining intended site at a moment after the joining process to identify the unjoined part occurring in the joining intended site, and if the identified unjoined part is caused by an intervening object, identifies the position of the intervening object;
a preparatory processing step that applies laser light to the intervening object present at the position identified in the identifying step, thereby deforming or subliming the intervening object; and
a correcting step that applies laser light to the unjoined part identified in the identifying step, thereby correcting the joined state at the unjoined part, after the preparatory processing step.
